# EUROPÄISCHE PATENTSCHRIFT

(11) **EP 2 187 719 B1**
(45) Veröffentlichungstag und Bekanntmachung des Hinweises auf die Patenterteilung: **24.09.2014**
(21) Anmeldenummer: 09014286.0
(22) Anmeldetag: 16.11.2009
(51) Int. Cl.: H05K 3/30

(54) **Verbindungsträger für Lötstifte**
Binder for solder pins
Support de raccordement pour broches de soudure

(30) Priorität: 17.11.2008 DE 102008057764
(43) Veröffentlichungstag der Anmeldung: 19.05.2010
(73) Patentinhaber: WILO SE, 44263 Dortmund (DE)
(72) Erfinder: Nowak, Dirk, 58455 Witten (DE)
(74) Vertreter: Cohausz Hannig Borkowski Wißgott

(56) Entgegenhaltungen:
- DE-A1- 4 422 787
- DE-A1-102006 030 135
- DE-U1-202004 020 555
- US-B1- 6 790 051
- BUNNELL KJ ET AL: "Circuit Pin Carrier" IP.COM JOURNAL, IP.COM INC., WEST HENRIETTA, NY, US, 1. November 1983 (1983-11-01), XP013037040 ISSN: 1533-0001

## Beschreibung

Die Erfindung betrifft eine Stiftleiste zur Montage auf einer gedruckten Leiterplatte mit einem Verbindungskörper, in dem zumindest zwei Lötstifte gehalten sind, die jeweils einen Lötbereich zum Verlöten der Lötstifte mit der Leiterplatte und einen Kontaktierbereich zur Aufnahme einer Buchsenleiste umfassen, wobei die Lötstifte zumindest mit ihren Lötbereichen eine in einer Ebene liegende Reihe bilden, mit dem Kontaktierbereich über eine obere, sich senkrecht zur Ebene erstreckende Körperfläche des Verbindungskörpers und mit dem Lötbereich über eine untere, sich senkrecht zur Ebene erstreckende Körperfläche des Verbindungskörpers hervorstehen. Weiterhin betrifft die Erfindung ein Verfahren zur Montage einer derartigen Stiftleiste auf der gedruckten Leiterplatte, die metallisierte Kontaktflächen zur Aufnahme der Lötbereiche der Lötstifte und zum Verlöten derselben mit den Lötbereichen aufweist.

Derartige Stiftleisten sind bekannt, beispielsweise aus dem US-Patent US 6,790,051 B1. Sie werden dazu verwendet, elektrisch kontaktierbare Anschlüsse auf gedruckten Schaltungen bereit zu stellen, um auf einfache Weise externe elektrische Komponenten mit der gedruckten Schaltung zu verbinden.

Aus der DE 10 2006 030 135 A1 ist eine Vorrichtung zur Montage von in einer Reihe angeordneten Kontaktstiften auf einer Leiterplatte bekannt, bei dem die Stifte mit ihren von der Leiterplatte abgewandten Enden in einem isolierenden Körper kraftschlüssig und gegen ein Verkippen geschützt aufgenommen sind. Der Körper weist eine Ansaugfläche für einen Bestückungsautomaten auf. Nach dem Einsetzen der Stifte in die Leiterplatte und nach dem Lötvorgang wird der Körper von den Stiften abgezogen, so dass diese frei in der Leiterplatte sitzen. Dadurch, dass eine Reihe von Lötstiften gemeinsam in einem Verbindungskörper gehalten wird, können mehrere Lötstifte gleichzeitig auf die Leiterplatte gesetzt werden.

Des Weiteren werden in der DE 44 22 787 A1 Stifte beschrieben, die an der Oberfläche gedruckter Schaltkreise befestigt werden können. Zur Platzierung eines einzelnen Stiftes wird in diesem Dokument vorgeschlagen, einen entfernbaren Stifthalter für diesen einzelnen Stift zu verwenden, der durch einen üblichen Saugkopf eines Beschickungsgerätes aufgenommen werden kann. Ein derartiger Stifthalter kann aus einem hochtemperarturbeständigen Kunststoff, beispielsweise aus Polyphenyl-Sulfit (PPS) oder aus Flüssigkristall-Polymer (LCP) bestehen, das eine Aufschmelzlötung mit einer Temperatur widerstehen kann, die üblicherweise im Bereich zwischen 230°C und 260°C liegt.

Stiftleisten stellen dabei eine vereinfachte Ausführung von Steckern bei Steckverbindern dar. Steckverbindungen umfassen eine Steckbuchse und einen Stecker, der mit der Leiterplatte verlötet wird und Rastelemente sowie Führungselemente zur Aufnahme der Steckbuchse aufweist. Der Stecker hat Lötstifte, die in einer Reihe angeordnet und zu den Seiten vollständig von einem beabstandeten Steckergehäuse umgeben sind. Die Lötstifte weisen jeweils einen unteren Lötbereich zum Verlöten mit der Leiterplatte und einen oberen Kontaktierbereich auf, der beim Aufstecken der Buchse auf den Stecker, bzw. Einstecken in das Steckergehäuse von Schneidklemmen oder Federklemmen kontaktierend umgriffen wird. Einfache Stiftleisten für die Leiterplattenmontage weisen demgegenüber kein Steckergehäuse auf.

Die Lötstiften der Stiftleiste stehen nach der Montage auf der Leiterplatte mit ihren Lötbereichen senkrecht von der Leiterplatte ab und ermöglichen das Aufstecken einer Buchsenleiste, Schraubklemme oder auch einzelner Kontaktierhülsen. Ferner ist auch das direkte Anlöten eines Kabels möglich. Das Ende des Lötbereichs ist in der Regel spitz zulaufend ausgebildet, so dass der Lötstift in eine auf der Leiterplatte vorhandene Bohrung eingesteckt werden kann.

Die Verbindungskörper nach dem Stand der Technik, in denen die Lötstifte gehalten sind, bestehen aus Polyester oder Nylon. Nachteilig ist hierbei, dass diese keine Beständigkeit gegen hohe Temperaturen aufweisen. Ein Verlöten derartiger Stiftleisten kann lediglich durch Handlöten oder Wellenlöten erfolgen, da an die Lötstifte bei diesem Lötverfahren nur für kurze Zeit, dass heißt 1-3 Sekunden eine Löttemperatur zwischen 180° C bis 250° C angelegt wird.

Bei SMD-Bauteilen (Surface-Mounted-Device) erfolgt die Montage auf einer geruckten Leiterplatte und das anschließende Verlöten der elektrischen Kontakte in einem sogenannten Reflow-Prozess. Bei diesem Verfahren wird zunächst Lötpaste vor der Bestückung auf die Leiterplatte aufgetragen. Dies erfolgt in der Regel mittels Schablonendruck, der auch Siebdruck genannt wird. Im nächsten Schritt werden die Bauteile bestückt und es schließt sich ein Aufschmelzen des Lotes an. Das Aufschmelzen erfolgt durch Aussetzen der bestückten Leiterplatte einer Temperatur im Bereich von ca. 280 °C für mehrere, insbesondere zwischen 8 und 15 Sekunden.

Einer derartigen Temperatur können Stiftleisten nach dem Stand der Technik nicht standhalten. Verbindungskörper aus Nylon oder Polyester schmelzen bei derartigen Temperaturen. Sie sind daher nicht geeignet, zusammen mit SMD-Bauteilen im Reflow-Verfahren verlötet zu werden. Das Bestücken und Verlöten muss vielmehr nach dem Lötvorgang der SMD-Bauteile von Hand erfolgen oder es müssen einzelne Lötstifte nacheinander, d.h. ohne Verbindungskörper, auf der Leiterplatte platziert werden, die dann im Reftow-Verfahren verlötet werden, In beiden Fällen entsteht durch die zusätzlichen Verfahrensschritte ein zeitlicher und wirtschaftlicher Mehraufwand, da eine Bestückung und/ oder dach Nachlöten manuell ausgeführt werden muss. Da die Lötstifte senkrecht ausgerichtet werden müssen, ist der Bestückungsvorgang ferner zeitaufwendig und muss sorgfältig durchgeführt werden.

Im Übrigen sind die Stiftleisten nach dem Stand der Technik nicht für ein Reflow-Verfahren geeignet, weil ihre Verbindungskörper mit der Unterseite auf der Leiterplatte plan aufliegen und ein Verlöten der Lötbereiche der Lötstifte von der anderen Seite der Leiterplatte erfolgt. Das Verlöten von Kontaktflächen auf der Leiterplatte, die innenseitig oder stirnseitig der Bohrungen auf der der Stiftleiste zugewandten Seite der Leiterplatte vorgesehen sind, mit den in die Bohrung einbringbaren Lötbereichen der Lötstiften, ist damit nicht möglich.

Aufgabe der vorliegenden Erfindung ist es daher, eine Stiftleiste zur Montage auf einer gedruckten Leiterplatte zur Verfügung zu stellen, die gemeinsam mit SMD-Bauteilen in einem Reflow-Lötprozess verlötet werden kann.

Diese Aufgabe wird durch die Merkmale des Anspruchs 1 gelöst, Vorteilhafte Weiterbildungen der Erfindung sind in den Unteransprüchen aufgeführt.

Erfindungsgemäß wird eine Stiftleiste zur Montage auf einer gedruckten Leiteplatte mit einem Verbindungskörper vorgeschlagen, in dem zumindest zwei Lötstifte gehalten sind, die jeweils einen Lötbereich zum Verlöten der Lötstifte mit der Leiterplatte und einen Kontaktierbereich zur Aufnahme einer Buchsenleiste umfassen, wobei die Lötstifte zumindest mit ihren Lötbereichen eine in einer Ebene liegende Reihe bilden, mit dem Kontaktierbereich über eine obere, sich senkrecht zur Ebene erstreckende Körperfläche des Verbindungskörpers und mit dem Lötbereich über eine untere, sich senkrecht zur Ebene erstreckende Körperfläche des Verbindungskörpers hervorstehen, und wobei der Verbindungskörper Stützfüße zur Abstützung der Stiftleiste auf der Leiterplatte aufweist, die an der unteren Körperfläche angeordnet sind und sich parallel zu den Lötstifte erstrecken, und der Verbindungskörper aus einem thermoplastischen hochtemperaturbeständigen Kunststoff besteht.

Die Stützfüße bilden Distanzelemente, durch die der Verbindungskörper der Stiftleiste in einem definierten Abstand zur Leiterplatte gehalten wird. Dies ermöglicht die Verwendung der Stiftleiste in einem Reflow-Prozess. Die bei diesem Verfahren auf die Leiterplatte mittels Siebdruck aufgebrachte Lötpaste gelangt durch die Stützfüße nicht mit dem Verbindungskörper in Berührung.

Die Lötstifte der Stiftleiste können derart ausgebildet sein, dass sie sich stiftartig von der Unterseite des Verbindungskörpers weg erstrecken. Die derart gebildeten Lötbereiche können in Bohrungen der Leiterplatte eingesetzt werden. In Verbindung mit einem Reflow-Lötprozess ist diese Art der Verbindungstechnik als sogenanntes "Pin-In-Paste"-Verfahren bekannt. Die Bohrungen der Leiterplatte sind zur Anwendung dieses Verfahrens durchkontaktiert, wobei sich die Bohrlöcher bei der Aufbringung der Lötpaste mit dieser entsprechend füllen. Durch das Einstecken der Stiftleiste in die Bohrlöcher drücken die Lötstifte die Lotpaste durch das Loch und bilden von der Form her einen charakteristischen Kopf aus. Durch das anschließende Reflow-Löten entsteht eine mechanische und elektrische Verbindung wie beim klassischen Wellenlötverfahren. In dieser Ausführungsvariante erstreckt sich der Lötstift über das auf der Leiterplatte auflegbare Ende der Stützfüße des Verbindungskörpers hinaus, so dass die Stiftleiste in entsprechende, auf der Leiterplatte vorhandene Bohrungen eingesteckt werden kann.

In einer alternativen Ausführungsvariante endet der Lötbereich der Lötstifte auf im Wesentlichen gleicher Höhe mit dem Ende der Stützfüße, mit dem diese auf der Leiterplatte aufliegen. Es ist in diesem Falle nicht notwendig, dass die Leiterplatte Bohrungen aufweist. Ein Verlöten der Stiftleiste mit der Leiterplatte kann vielmehr durch auf dieser vorgesehene ebene Kontaktflächen, so genannte Lötpads erfolgen. Dadurch, dass die für das Reflow-Verfahren zu verwendende Lötpaste klebrig ist, haftet die Stiftleiste nach dem Aufsetzen auf die Leiterplatte, d. h. durch Einbringen der Lötbereiche der Lötstifte in die Lötpaste auf der Leiterplatte.

Durch die Stützfüße wird unterhalb des Verbindungskörpers ausreichend Freiraum für die Lötpaste zur Verfügung gestellt. Weiterhin wird ein guter Wärmezugang zu den zu verlötenden Stellen gewährleistet, so dass die zum Verlöten notwendige Temperatur zwischen 250°C bis 280°C durch das Beströmen der Lötbereiche mit Heißluft erreicht werden kann.

Vorzugsweise können die Stützfüße in Erstreckungsrichtung der Reihe der Lötstifte jeweils am Ende des Verbindungskörpers angeordnet sein. Hierdurch wird gewährleistet, dass der Verbindungskörper in Erstreckungsrichtung der Stiftleiste parallel zur Leiterplatte ausgerichtet und auf diese aufgesetzt werden kann. Ein schiefes Aufsetzen wird dadurch vermieden und weiterhin gewährleistet, dass zwischen der unteren Körperfläche und der Leiterplatte ein stets gleicher Abstand vorliegt.

In einer vorteilhaften Weiterbildung der Erfindung weisen die Lötstifte jeweils einen Flansch auf, auf dem der Verbindungskörper mit der unteren Körperfläche aufliegt. Der Flansch kann insbesondere ringförmig ausgebildet sein. Er gewährleistet hinsichtlich des Herstellungsvorganges der Stiftleiste, beispielsweise durch Umspritzung der Lötstifte mit dem thermoplastischen Kunststoff zur Ausbildung des Verbindungskörpers, eine senkrechte Ausrichtung der Lötstifte. Die Breite des Ringflansches in axialer Richtung eines Lötstiftes ist vorzugsweise geringfügig kleiner als die Höhe der Stützfüße, so dass zwischen der der Leiterplatte zugewandten Stirnseite des Ringflansches und der Leiterplatte ausreichend Platz für die Aufnahme der Lötpaste gegeben ist. Durch den Lötprozess wird die besagte Stirnseite ebenfalls mit Lot verbunden. Der Ringflansch bewirkt dadurch eine Vergrößerung der für die Verbindung des Lötstiftes mit der Lötpaste vorgesehenen Oberfläche und bietet daher einen besonders guten elektrischen Übergang mit geringem ohmschen Widerstand. Hierdurch wird ermöglicht, dass über die Kontaktstifte jeweils ein höherer Strom geleitet werden kann. Durch den geringen Kontaktwiderstand werden ohmsche Verluste des Weiteren reduziert. Durch die Verlötung des Flansches mit der entsprechenden Kontaktfläche auf der Leiterplatte wird ferner eine besonders gute mechanische Verbindung gewährleistet, so dass die Stiftleiste besonders fest und robust auf der Leiterplatte montiert ist.

In der Ausführungsvariante der Stiftleiste mit Lötstiften, die nicht in eine entsprechende Bohrung auf der Leiterplatte eingesetzt werden, sondern vielmehr mit auf der Leiterplatte vorhandenen ebenen Kontaktflächen verlötet werden, kann der jeweilige Flansch eines Lötstiftes dessen unteres Ende und damit den Lötbereich des Lötstiftes bilden. Der Flansch kann dabei mit dem unteren axialen Ende des Lötstiftes eine gemeinsame, ebene, zur Leiterplatte gerichtete Stirnfläche bilden, die mittels der Lötpaste mit der entsprechenden Kontaktfläche auf der Leiterplatte verlötet werden kann.

In einer vorteilhaften Weiterbildung der Stiftleiste kann der Verbindungskörper zumindest im Bereich eines Lötstiftes oder im Bereich zwischen zwei Lötstiften eine Erweiterung aufweisen, die sich senkrecht von der Ebene weg erstreckt und zumindest die obere Körperfläche eben verlängert. Durch die Erweiterung wird der Verbindungsträger derart verbreitert, dass die obere Körperfläche eine ausreichende Größe aufweist, um eine Ansaugfläche für eine Vakuumpipette zu bilden, die eine automatisierte Leiterplattenmontage durch einen Bestückungsautomaten ermöglicht.

Vorzugsweise kann vorgesehen sein, dass die Erweiterung nur im Bereich eines Lötstiftes, im Falle der Anordnung von mehr als zwei Lötstiften nur im Bereich von zwei Lötstiften oder im Bereich zwischen zwei Lötstiften vorgesehen ist. Dies bedeutet, dass der Verbindungskörper im Bereich der anderen Lötstifte nicht verbreitert ist, so dass für die Herstellung des Verbindungskörpers verwendete Kunststoffmaterial eingespart werden kann.

In einer vorteilhaften Weiterbildung kann der Verbindungskörper zumindest im Bereich eines Lötstiftes oder im Bereich zwischen zwei Lötstiften zwei sich gegenüberliegende Erweiterungen aufweisen, die sich senkrecht von der Ebene weg erstrecken und zumindest die obere Körperfläche eben verlängern. Durch die Verwendung einer der ersten Erweiterung gegenüber liegenden zweiten Erweiterung kann die Länge der ersten Erweiterung reduziert werden. Vorzugsweise können die beiden Erweiterungen derart ausgebildet sein, dass sie die obere Körperfläche zu beiden Seiten der Lötstiftreihe in gleichem Maße verlängert, d.h. dass die Erweiterungen im Wesentlichen dieselbe Länge aufweisen. Die Vakuumpipette kann damit mit ihrem Saugmund in der Mitte der durch die beiden Erweiterungen gebildeten Gesamterstreckung angesetzt werden, wobei die Mitte in der Ebene liegt, die von der Lötstiftreihe gebildet wird.

In einer weiteren vorteilhaften Weiterbildung der Erfindung kann der Verbindungskörper Stützfüße aufweisen, die an den Unterseiten der Erweiterungen angeordnet sind und die sich parallel zu den Lötstifte erstrecken. Die Stützfüße dienen ebenfalls der Abstützung der Stiftleiste auf der Leiterplatte und gewährleisten, dass die Stiftleiste in der die Lötstiftreihe bildenden Ebene senkrecht zur Leiterplatte auf dieser montiert wird. Ein Verkippen der Stiftleiste um die Achse, die die Schnittgerade der Ebene, in der die Lötstifte liegen, und der Leiterplatte bildet, wird dadurch vermieden.

Vorzugsweise kann die Stiftleiste mehr als zwei Lötstifte, insbesondere drei, vier oder mehr Stifte aufweisen. Damit kann für jeden Anwendungsfall einer spezifischen elektrischen Kontaktierung eine geeignete Stiftleiste zur Verfügung gestellt werden.

Es ist besonders vorteilhaft, die Erweiterung bzw. die Erweiterungen in Erstreckungsrichtung der Reihe der Lötstifte mittig anzuordnen. Hierdurch wird ein sicheres Aufsetzen der Stiftleiste auf die Leiterplatte parallel zu dieser gewährleistet, da die Ansaugfläche für eine Vakuumpipette in diesem Fall ebenfalls in der Mitte des Verbindungskörpers vorliegt, die dem Schwerpunkt der Stiftleiste in Richtung der Erstreckung der Lötstiftenreihe sowie in Richtung der Erweiterungen entspricht.

Als hochtemperaturbeständiger Kunststoff kann vorzugsweise Polyphenylensulfid (PPS) verwendet werden. Dieses Material ist neben seiner hohen Temperaturbeständigkeit auch gegen Chemikalien besonders beständig, und weist auch bei höheren Temperaturen eine gute Steifigkeit, Festigkeit und Kriechfestigkeit auf. Aufgrund der guten thermischen und mechanischen Beständigkeit eignet sich PPS besonders gut für die Ausbildung des Verbindungskörpers der Stiftleiste durch Spritzgießen. Vorzugsweise kann das Polyphenylensulfid mit Glasfaserverstärkungen oder Glasfaser-/Mineral-Verstärkungsstoffkombinationen verwendet werden. Hierdurch wird die thermische und mechanische Belastbarkeit des Materials zusätzlicih erhöht.

Erfindungsgemäß wird weiterhin ein Verfahren zur Montage der Stiftleiste auf einer gedruckten Leiterplatte mit Kontaktflächen zum Verlöten mit den Lötbereichen der Lötstifte vorgeschlagen, wobei auf die Kontaktflächen zunächst Lötpaste aufgetragen wird, die Stiftleiste danach mittels einer Vakuumpipette derart genommen wird, dass der Saugmund der Vakuumpipette an der oberen Körperfläche des Verbindungskörpers anliegt, wobei in der Vakuumpipette ein Unterdruck derart erzeugt wird, dass der Verbindungskörper an den Saugmund der Vakuumpipette gesaugt wird, wobei die Stiftleiste danach mittels der Vakuumpipette auf die gedruckte Leiterplatte derart gesetzt wird, dass die Lötbereiche der Lötstifte mit der Lötpaste der entsprechenden Kontaktfläche in Verbindung gebracht werden, und wobei die Lötbereiche der Lötstifte anschließend mit den Kontaktflächen verlötet werden.

Das Verlöten der Lötstifte mit den Kontaktflächen kann beispielsweise dadurch erfolgen, dass ein Strom von Heißluft, insbesondere mit einer Temperatur zwischen 260°C und 285°C, vorzugsweise mit einer Temperatur von 280°C auf die bestückte Leiterplatte gerichtet wird, so dass die Lötpaste aufgeschmolzen wird und sich mit dem Lötbereich der Lötstifte und der Kontaktflächen verbindet. Die auf der Leiterplatte vorgesehenen Kontaktflächen können eben ausgebildet sein oder innenseitig einer Bohrung zur Aufnahme der Lötstifte der Stiftleiste im Sinne einer durchkontaktierten Bohrung vorliegen.

Das erfindungsgemäße Verfahren ermöglicht die Integration der Bestückung einer Leiterplatte mit einer erfindungsgemäßen Stiftleiste in einem automatisierten Bestückungsprozess zusammen mit SMD-Bauteilen sowie das anschließende Verlöten aller Bauteile auf der Leiterplatte durch einen einzigen gemeinsamen Reflow-Lötprozess. Die herkömmlichen Verfahren zur Bestückung und zum Verlöten von Leiterplatten mit Stiftleisten können dadurch erheblich beschleunigt und vereinfacht werden. Weitere Vorteile und Merkmale der erfindungsgemäßen Stiftleiste sowie des erfindungsgemäßen Verfahrens sind in der nachfolgenden Beschreibung eines bevorzugten Ausführungsbeispiels anhand der beigefügten Figuren erläutert.

Es zeigen:
- Figur 1:: Vorderansicht der Stiftleiste
- Figur 2:: Stirnseitenansicht der Stiftleiste
- Figur 3:: Stiftleiste in Draufsicht
- Figur 4:: Ansicht der Stiftleiste von unten
- Figur 5:: Perspektivische Ansicht der Stiftleiste

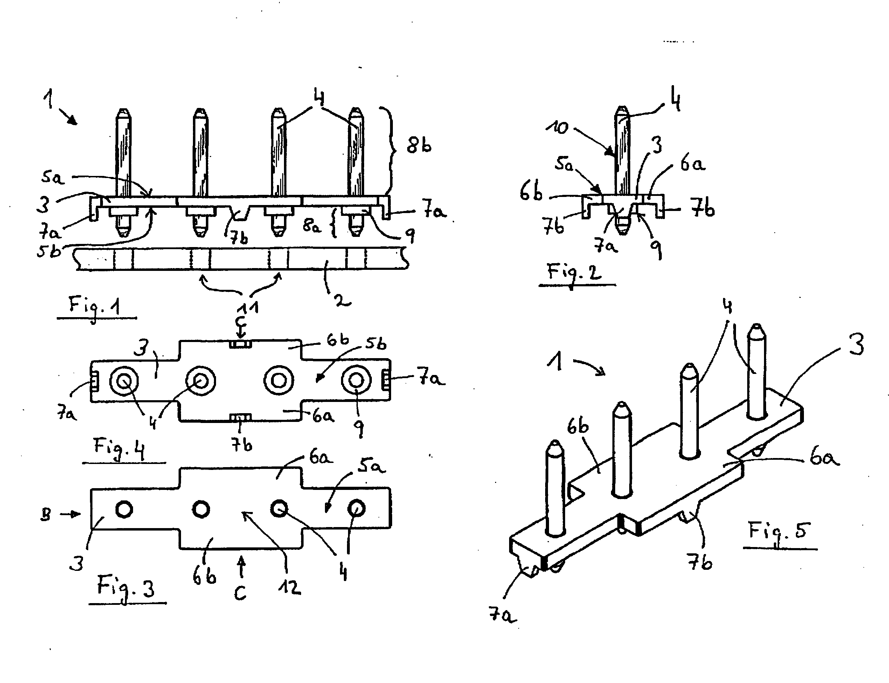

Figur 1 zeigt eine erfindungsgemäße Ausführungsvariante einer Stiftleiste 1 zur Montage auf einer gedruckten Leiterplatte 2. Die Stiftleiste 1 besteht aus einem Verbindungskörper 3, in dem vier Lötstifte 4 gehalten sind. Die Lötstifte 4 sind als Rundstifte ausgebildet und vorzugsweise aus Messing hergestellt. Die Oberfläche 10 der Lötstifte 4 ist verzinnt. Die Lötstifte 4 liegen in dem Verbindungskörper 3 derart ein, dass dieser die Lötstifte 4 in einen Lötbereich 8a zum Verlöten der Lötstifte 4 mit der Leiterplatte 2 und in einem Kontaktierbereich 8b zur Aufnahme einer Buchsenleiste, Steck-Schraubklemme oder einzelnen Kontakthülse trennt. Die Lötstifte 4 sind in einem Abstand zueinander äquidistant angeordnet, wobei der Verbindungskörper 3 einen Isolierkörper bildet.

Die Lötstifte 4 sind geradlinig ausgebildet, so dass die Achse des Lötbereichs 8a mit der Achse des Kontaktierbereichs 8b identisch ist. Die Anordnung der Lötstifte 4 bildet somit eine in einer Ebene liegende Reihe. In einer nicht dargestellten Ausführungsvariante können die Kontaktierbereiche 8b winklig, insbesondere rechtwinklig, zu der besagten Ebene ausgebildet sein, so dass beispielsweise eine Buchsenleiste in zu der Leiterplatte 2 paralleler Richtung auf die Stiftleiste 1 gesteckt werden kann.

Die Kontaktierbereiche 8b stehen über eine obere, sich senkrecht zur Ebene erstreckenden Körperfläche 5a des Verbindungskörpers hervor. Weiterhin stehen die Lötstifte mit ihrem Lötbereich 8a über eine untere, sich senkrecht zur Ebene erstreckende Körperfläche 5b des Verbindungskörpers 3 hervor.

Erfindungsgemäß weist der Verbindungskörper 3 Stützfüße 7a zur Abstützung der Stiftleiste 1 auf der Leiterplatte 2 auf, die an der unteren Körperfläche 5b angeordnet sind und sich parallel zu den Lötstiften 4 erstrecken. Die Stützfüße 7a sind einstückig mit dem Verbindungskörper 3 ausgebildet und jeweils endseits des Verbindungskörpers in Erstreckungsrichtung der Lötstiftenreihe angeformt. Die Erstreckungsrichtung der Lötstiftenreihe ist in Figur 3 mit dem Buchstaben B bezeichnet. Die Stützfüße 7a stellen Distanzelemente dar und bewirken, dass der Verbindungskörper 3 mit seiner unteren Körperfläche 5b nicht plan auf der Leiterplatte 2 aufliegt sondern unterhalb dieser unteren Körperfläche 5b nach der Montage der Stiftleiste 1 auf der gedruckten Leiterplatte 2 ausreichend Freiraum zur Verfügung steht, damit die für den Verlötprozess notwendige Hitze an die Lötbereiche 8a der Lötstifte 4 gelangen kann.

Die Hitze kann beispielsweise in Form von Heißluft an die Lötbereiche 8a gebracht werden. Die Heißluft kann beispielsweise ein Temperatur von 260°C bis 285°C, vorzugsweise eine Temperatur von 280°C aufweisen, und für mehrere Sekunden, insbesondere zwischen 8 und 15 Sekunden, vorzugsweise 10 Sekunden, an die mit der Stiftleiste bestückten Leiterplatte angelegt werden. Erfindungsgemäß besteht der Verbindungskörper aus einem thermoplastischen hochtemperaturbeständigen Kunststoff, der den genannten Lötbedingungen widersteht. Als Kunststoff kann hier Polyvenylensulfid (PPS) verwendet werden der eine ausgezeichnete thermische, mechanische und auch chemische Beständigkeit aufweist. PPS besitzt einen Schmelzpunkt von ca. 285°C und kann in einem Spritzgießverfahren gut verarbeitet werden. Insbesondere kann PPS mit Glasfaserverstärkungen oder Glasfaser-/Mineral-Verstärkungsstoffkombinationen versehen werden, die dem Verbindungskörper zusätzliche mechanische Steifigkeit und Festigkeit verleiht.

Die Lötstifte 4 weisen jeweils einen Flansch 9, auf dem der Verbindungskörper 3 mit seiner unteren Körperfläche 5b aufliegt. Wie in Figur 4 gezeigt, ist der Flansch eines Lötstiftes 4 ringförmig ausgebildet, wobei seine axiale Erstreckung in Richtung der Lötstiftachse geringer ist als die Höhe der Stützfüße 7a. Dies gewährleistet, dass nach dem Aufsetzen der Stiftleiste 1 auf die Leiterplatte 2 zwischen der der Leiterplatte 2 zuwandten Stirnseite eines Ringflansches 9 und der dieser Stirnseite gegenüberliegenden Kontaktfläche auf der Leiterplatte ein Depot an Lötpaste vorgesehen werden kann, mit welchem der Lötbereich 8a respektive die besagte Stirnfläche des Ringflansches 9 mit der entsprechenden Kontaktfläche auf der Leiterplatte 2 verlötet werden kann.

In Figur 1 ist beispielhaft dargestellt, dass der Lötbereich 8a ebenfalls stiftförmig ausgebildet ist, so dass für die Verbindung der Stiftleiste 1 mit der Leiterplatte 2 Bohrungen 11 in der Leiterplatte 2 vorgesehen werden müssen. In dieser Ausführungsvariante sind die Bohrungen durchkontaktiert, so dass die Kontaktflächen innenseitig der Bohrungen 11 sowie ringförmig um die zur Stiftleiste 1 gerichtete Öffnung der Bohrung 11 herum auf der Leiterplatte in Form eines Kragens vorgesehen sind.

Für eine automatisierte Bestückung der Leiterplatte mit der Stiftleiste 1 nach Figur 1 in demselben Prozess, in dem auch SMD-Bauteile auf die Leiterplatte 2 gesetzt werden, ist es erforderlich, auf der Stiftleiste 1 eine Saugfläche 12 bereit zu stellen an die eine Vakuumpipette mit ihrem Saugmund angesetzt werden kann. Hierfür ist die obere Körperfläche 5a eben und glatt ausgebildet und im Bereich der beiden mittleren Lötstifte 4 durch jeweils eine Erweiterung 6a und 6b zu den Seiten verlängert. Die Erweiterungen 6a und 6b bilden Vorsprünge, die gegenüber den nicht verbreiterten Seitenflächen des Verbindungskörpers 3 im Bereich der beiden äußeren Lötstifte 4 hervorspringen. Die Breite des Verbindungskörpers 3, gesehen in einer Richtung senkrecht zu der die Lötstiftenreihe bildenden Ebene ist im Bereich der äußeren Lötstifte 4 geringfügig breiter als der Außendurchmesser eines Ringflansches 9, wobei der Durchmesser eines Ringflansches 9 etwa doppelt so groß wie der Durchmesser eines Lötstiftes 4 ist. Demgegenüber ist der Verbindungskörper 3 im Bereich der mittleren Lötstifte 4 verbreitert. In diesem Bereich ist die Breite des Verbindungskörpers im Wesentlichen doppelt so groß wie seine Breite im Bereich der beiden äußeren Lötstifte 4. Das Verhältnis der Breiten des Verbindungskörpers entlang der Erstreckungsrichtung B der Reihe der Lötstifte 4 ist in den Figuren 2 bis 4 erkennbar. Die unterschiedlichen Breiten des Verbindungskörpers dienen der Einsparung von Material, da die Stiftleiste lediglich eine einzige Saugfläche aufzuweisen braucht, um von einer Vakuumpipette im Rahmen eines automatisierten Montageprozesses aufgenommen zu werden.

Figur 2 zeigt eine Stirnseitenansicht der erfindungsgemäßen Stiftleiste 1 gemäß Figur 1. Die Stirn wird durch den schmalen Teil des Verbindungskörpers 3 im Bereich des linken äußeren Lötstifte 4 gemäß Figur 1 gebildet. Figur 2 zeigt anschaulich, dass sich die Erweiterungen 6a und 6b symmetrisch zu der Ebene der Lötstiftenreihe von dieser Ebene weg erstrecken und jeweils Vorsprünge gegenüber den Seitenflächen des schmalen Bereichs des Verbindungskörpers 3 bilden.

Figur 3 zeigt eine Draufsicht der erfindungsgemäßen Stiftleiste 1. Zwischen den mittleren beiden Lötstiften 4 ist die Saugfläche 12 gebildet, an der die Stiftleiste 1 durch eine Vakuumpipette mit ihrem Saugmund genommen werden kann. Die Erstreckungsrichtung der Erweiterungen 6a und 6b senkrecht zu der Ebene der Lötstiftenreihe ist in Figur 3 mit dem Buchstaben C gekennzeichnet.

Figur 4 zeigt eine Darstellung der Stiftleiste 1 von unten. Die Darstellung zeigt die Füße 7a und die zur Leiterplatte 2 gerichtete Stirnfläche des Ringflansches 9 in Draufsicht.

Die Erweiterungen 6a und 6b weisen jeweils in der Erstreckungsrichtung C an ihren äußeren Enden Kontaktfüße 7b auf. Sie sind an der Unterseite der Erweiterungen 6a, 6b angeformt und einstückig mit dem Verbindungskörper 3 ausgebildet. Sie erstrecken sich weiterhin parallel zu den Lötstiften 4 und liegen auf der Leiterplatte im montierten Zustand der Stiftleiste 1 auf. In Erstreckungsrichtung C weisen die Stützfüße 7b eine Breite auf, die in etwa der Hälfte der Breite der Erweiterungen 6a und 6b entspricht. Weiterhin sind die Stützfüße 7b in Erstreckungsrichtung B, siehe Figur 3, mittig angeordnet. Die Stützfüße 7b gewährleisten ein zur Leiterplatte 2 rechtwinkliges aufsetzen der Stiftleiste 1 auf die Leiterplatte 2.

Figur 5 zeigt eine perspektivische Ansicht der erfindungsgemäßen Stiftleiste 1. Die axialen Enden der Lötstifte 4 sind jeweils abgerundet und die Kanten des Verbindungskörpers 3 gefast.

Eine Stiftleiste gemäß den Figuren 1 bis 5 ermöglicht die Verwendung innerhalb einer automatisierten Montagelinie zur Bestückung einer gedruckten Leiterplatte 2 zusammen mit SMD-Bauteilen, die gemeinsam in einem Reflow-Lötverfahren mit der Leiterplatte 2 verlötet werden. Die Montage und das Verlöten der Stiftleiste auf der Leiterplatte 2 kann dabei mittels eines "Pin-in-Paste"-Verfahrens, wie es für die Montage einzelner Lötstifte auf einer Leiterplatte bekannt ist, erfolgen.

Erfindungsgemäß ist zur Montage der Stiftleiste nach den Figuren 1 bis 5 auf der gedruckten Leiterplatte 2 vorgesehen, dass auf die Kontaktflächen der Leiterplatte 2 zunächst Lötpaste aufgetragen wird. Dies kann mittels einer entsprechend ausgeschnitten und positionierten Schablone erfolgen, wobei die Lötpaste mittels Siebdruck auf die Leiterplatte 2 aufgebracht wird. Die Bohrlöcher 11 der Leiterplatte 2 füllen sich dadurch mit Lötpaste. Anschließend wird die Stiftleiste 1 mittels einer Vakuumpipette derart genommen, dass der Saugmund der Vakuumpipette an der oberen Körperfläche 5a des Verbindungskörpers 3 im Bereich der Saugfläche 12 anliegt, wobei in der Vakuumpipette ein Unterdruck derart erzeugt wird, dass der Verbindungskörper 3 an den Saugmund der Vakuumpipette gesaugt wird. Anschließend wird die Stiftleiste mittels der Vakuumpipette auf die gedruckte Leiterplatte derart aufgesetzt, dass die Lötbereiche 8a der Lötstifte 4 mit der Lötpaste der entsprechenden Kontaktfläche in Verbindung gebracht werden. Durch die stiftartige Ausbildung der Lötbereiche 8a wird die Lötpaste durch die Bohrung 11 gedrückt und bildet von der Form her einen charakteristischen Streichholzkopf aus. Anschließend erfolgt das Verlöten der Kontaktflächen mit den Lötbereichen 8a der Lötstifte 4 in einem Reflow-Lötverfahren, so dass eine mechanisch feste und elektrisch sichere Verbindung zwischen den Lötstiften 4 der Stiftleiste 1 und den Kontaktflächen der Leiterplatte 2 hergestellt wird.

Dieses Verfahren ermöglicht eine vollautomatische Verarbeitung einer Reihe von Lötstiften gleichzeitig, die in dem Verbindungskörper 3 gehalten sind. Ein Einsetzen der Lötstifte von Hand kann dadurch vermieden werden. Durch den Verbindungsträger 3 werden die Lötstifte 4 unmittelbar in der richtigen Position und derselben Höhe gehalten, wobei die Stützfüße 7a, 7b für eine senkrechte Ausrichtung der Stiftleiste auf der Leiterplatte 2 sorgen, sofern die Stützfüße 7a, 7b auf der Leiterplatte 2 aufliegen. Durch die Ausbildung des Verbindungskörpers 3 aus einem thermoplastischen hochtemperaturbeständigen Kunststoff werden die Lötstifte in einem SMD-Reflow-Lötprozess verarbeitbar, und weitere Lötprozesse, insbesondere manuell durchgeführte Lötprozesse, können dadurch vermieden werden.

Durch die Ausbildung einer ebenen Saugfläche 12 auf der oberen Körperfläche 5a durch die Erweiterungen 6a, 6b wird die Verwendung einer herkömmlichen Vakuumpipette ermöglicht, die auch zur Aufnahme von SMD-Bauteilen eingesetzt wird. Es sind dadurch keine speziellen Werkzeuge oder Vorrichtungen für einen automatisierten Montageprozess notwendig. Hierdurch kann die Montage erfindungsgemäßer Stiftleisten 1 auf Leiterplatten 2 einfach in voll automatisierte Montageverfahren mit Bestückungsautomaten integriert werden. Dadurch wird eine Erhöhung der Fertigungsqualität und eine Verkürzung der Prozesszeiten erreicht.

## Patentansprüche

1. Stiftleiste (1) zur Montage auf einer gedruckten Leiterplatte (2) mit einem Verbindungskörper (3), in dem zumindest zwei Lötstifte (4) gehalten sind, die jeweils einen Lötbereich (8a) zum Verlöten der Lötstifte (4) mit der Leiterplatte (2) und einen Kontaktierbereich (8b) umfassen, wobei die Lötstifte (4) zumindest mit ihren Lötbereichen (8a) eine in einer Ebene liegende Reihe bilden, mit dem Kontaktierbereich (8b) über eine obere, sich senkrecht zur Ebene erstreckende Körperfläche (5a) des Verbindungskörpers (3) und mit dem Lötbereich (8a) über eine untere, sich senkrecht zur Ebene erstreckende Körperfläche (5b) des Verbindungskörpers (3) hervorstehen, wobei der Verbindungskörper (3) Stützfüße (7a) zur Abstützung der Stiftleiste (1) auf der Leiterplatte (2) aufweist, die an der unteren Körperfläche (5b) angeordnet sind und sich parallel zu den Lötstiften (4) erstrecken, **dadurch gekennzeichnet, dass** der Verbindungskörper (3) aus einem thermoplastischen Hochtemperatur beständigen Kunststoff besteht.

2. Stiftleiste (1) nach Anspruch 1, **dadurch gekennzeichnet, dass** die Stützfüße (7a) in Erstreckungsrichtung der Reihe der Lötstifte (4) jeweils am Ende des Verbindungskörpers angeordnet sind.

3. Stiftleiste (1) nach Anspruch 1 oder 2, **dadurch gekennzeichnet, dass** die Lötstifte (4) jeweils einen Flansch (9) aufweisen, auf dem der Verbindungskörper (3) mit der unteren Körperfläche (5b) aufliegt.

4. Stiftleiste (1) nach Anspruch 3, **dadurch gekennzeichnet, dass** der Flansch (9) den Lötbereich (8a) und das untere Ende eines Lötstiftes (4) bildet.

5. Stiftleiste (1) nach einem der vorherigen Ansprüche, **dadurch gekennzeichnet, dass** der Verbindungskörper (3) zumindest im Bereich eines Lötstiftes (4) oder im Bereich zwischen zwei Lötstiften (4) eine Erweiterung (6a, 6b) aufweist, die sich senkrecht von der Ebene weg erstreckt und die obere Körperfläche (5a) eben verlängert.

6. Stiftleiste (1) nach einem der vorherigen Ansprüche, **dadurch gekennzeichnet, dass** der Verbindungskörper (3) zumindest im Bereich eines Lötstiftes (4) oder im Bereich zwischen zwei Lötstiften (4) zwei sich gegenüberliegende Erweiterungen (6a, 6b) aufweist, die sich senkrecht von der Ebene weg erstrecken und die obere Körperfläche (5a) eben verlängern.

7. Stiftleiste (1) nach Anspruch 6, **dadurch gekennzeichnet, dass** sich die Erweiterungen (6a, 6b) symmetrisch zu beiden Seiten senkrecht zu der Ebene erstrecken und die obere Körperfläche (5a) im gleichen Maße verlängern.

8. Stiftleiste (1) nach Anspruch 6 oder 7, **dadurch gekennzeichnet, dass** der Verbindungskörper (3) Stützfüße (7b) zur Abstützung der Stiftleiste (1) auf der Leiterplatte (2) aufweist, die an der Unterseite der Erweiterung (6a, 6b) angeordnet sind und sich parallel zu den Lötstiften (4) erstrecken.

9. Stiftleiste (1) nach Anspruch 8, **dadurch gekennzeichnet, dass** die Stützfüße (7b) der Erweiterungen (6a, 6b) in Erstreckungsrichtung (C) derselben senkrecht zur Ebene betrachtet jeweils im Bereich der äußeren Enden der Erweiterung (6a, 6b) angeordnet sind.

10. Stiftleiste (1) nach einem der vorherigen Ansprüche 6 bis 9, **dadurch gekennzeichnet, dass** die Erweiterungen (6a, 6b) in Erstreckungsrichtung (B) der Reihe der Lötstifte (4) mittig angeordnet sind.

11. Stiftleiste (1) nach einem der vorherigen Ansprüche, **dadurch gekennzeichnet, dass** der Kunststoff Polyphenylensulfid (PPS) ist.

12. Verfahren zur Montage einer Stiftleiste (1) gemäß einem der Ansprüche 1 bis 11 auf einer gedruckten Leiterplatte (2) mit Kontaktflächen zum Verlöten derselben mit den Lötbereichen (8a) der Lötstifte (4), wobei zunächst auf die Kontaktflächen Lötpaste aufgetragen wird, **dadurch gekennzeichnet, dass**, die Stiftleiste (1) mittels einer Vakuumpipette derart genommen wird, dass der Saugmund der Vakuumpipette an der oberen Körperfläche (5a) des Verbindungskörpers (3) anliegt, wobei in der Vakuumpipette ein Unterdruck derart erzeugt wird, dass der Verbindungskörper (3) an den Saugmund der Vakuumpipette gesaugt wird, dass die Stiftleiste (1) mittels der Vakuumpipette auf die gedruckte Leiterplatte (2) derart gesetzt wird, dass die Lötbereiche (8a) der Lötstifte (4) mit der Lötpaste der entsprechenden Kontaktfläche in Verbindung gebracht werden, und dass die Lötbereiche (8a) der Lötstifte (4) anschließend mit den Kontaktflächen verlötet werden.

## Claims

1. Pin connector (1) for mounting on a printed circuit board (2) with a connecting body (3), held in which are at least two solder pins (4), which in each case comprise a soldering region (8a) for soldering the solder pins (4) to the circuit board (2) and a contacting region (8b), the solder pins (4) forming at least with their soldering regions (8a) a row that lies in one plane, protruding with the contacting region (8b) beyond an upper body area (5a) of the connecting body (3) that extends perpendicularly in relation to the plane and protruding with the soldering region (8a) beyond a lower body area (5b) of the connecting body (3) that extends perpendicularly in relation to the plane, the connecting body (3) having supporting feet (7a) for supporting the pin connector (1) on the circuit board (2), which are arranged on the lower body area (5b) and extend parallel to the solder pins (4), **characterized in that** the connecting body (3) consists of a thermoplastic high-temperature-resistant plastic.

2. Pin connector (1) according to Claim 1, **characterized in that** the supporting feet (7a) are in each case arranged at the end of the connecting body in the direction of extent of the row of solder pins (4).

3. Pin connector (1) according to Claim 1 or 2, **characterized in that** the solder pins (4) in each case have a flange (9), on which the connecting body (3) rests with the lower body area (5b).

4. Pin connector (1) according to Claim 3, **characterized in that** the flange (9) forms the soldering region (8a) and the lower end of a solder pin (4).

5. Pin connector (1) according to one of the preceding claims, **characterized in that** the connecting body (3) has at least in the region of a solder pin (4) or in the region between two solder pins (4) a widening (6a, 6b), which extends perpendicularly away from the plane and extends the upper body area (5a) in a planar manner.

6. Pin connector (1) according to one of the preceding claims, **characterized in that** the connecting body (3) has at least in the region of a solder pin (4) or in the region between two solder pins (4) two opposing widenings (6a, 6b), which extend perpendicularly away from the plane and extend the upper body area (5a) in a planar manner.

7. Pin connector (1) according to Claim 6, **characterized in that** the widenings (6a, 6b) extend symmetrically to both sides perpendicularly in relation to the plane and extend the upper body area (5a) to the same extent.

8. Pin connector (1) according to Claim 6 or 7, **characterized in that** the connecting body (3) has supporting feet (7b) for supporting the pin connector (1) on the circuit board (2), which are arranged on the underside of the widening (6a, 6b) and extend parallel to the solder pins (4).

9. Pin connector (1) according to Claim 8, **characterized in that** the supporting feet (7b) of the widenings (6a, 6b) are in each case arranged in the region of the outer ends of the widening (6a, 6b), as seen in the direction of extent (C) of the same perpendicularly in relation to the plane.

10. Pin connector (1) according to one of the preceding Claims 6 to 9, **characterized in that** the widenings (6a, 6b) are arranged centrally in the direction of extent (B) of the row of solder pins (4).

11. Pin connector (1) according to one of the preceding claims, **characterized in that** the plastic is polyphenylene sulphide (PPS).

12. Method for mounting a pin connector (1) according to one of Claims 1 to 11 on a printed circuit board (2) with contact areas for soldering the same to the soldering regions (8a) of the solder pins (4), solder paste first being applied to the contact areas, **characterized in that** the pin connector (1) is taken by means of a vacuum pipette in such a way that the suction mouth of the vacuum pipette lies against the upper body area (5a) of the connecting body (3), a negative pressure being produced in the vacuum pipette in such a way that the connecting body (3) is sucked onto the suction mouth of the vacuum pipette, **in that** the pin connector (1) is placed by means of the vacuum pipette onto the printed circuit board (2) in such a way that the soldering regions (8a) of the solder pins (4) are brought into connection with the solder paste of the corresponding contact area, and **in that** the soldering regions (8a) of the solder pins (4) are subsequently soldered to the contact areas.

## Revendications

1. Barrette à broches (1) pour le montage sur une carte à circuits imprimés (2), comprenant un corps de connexion (3) dans lequel sont retenues au moins deux broches de brasage (4), lesquelles comprennent chacune une zone de brasage (8a) pour braser les broches de brasage (4) à la carte à circuits imprimés (2) et une zone de contact (8b), les broches de brasage (4) formant au moins avec leurs zones de brasage (8a) une rangée située dans un plan, faisant saillie avec la zone de contact (8b) au-delà d'une surface de corps supérieure (5a) du corps de connexion (3) s'étendant perpendiculairement au plan et avec la zone de brasage (8a) au-delà d'une surface de corps inférieure (5b) du corps de connexion (3) s'étendant perpendiculairement au plan, le corps de connexion (3) présentant des pattes d'appui (7a) pour supporter la barrette à broches (1) sur la carte à circuits imprimés (2), lesquelles sont disposées sur la surface de corps inférieure (5b) et s'étendent parallèlement aux broches de brasage (4), **caractérisée en ce que** le corps de connexion (3) se compose d'un plastique thermoplastique résistant aux hautes températures.

2. Barrette à broches (1) selon la revendication 1, **caractérisée en ce que** les pattes d'appui (7a) sont disposées dans la direction d'étendue de la rangée de broches de brasage (4) à chaque fois à l'extrémité du corps de connexion.

3. Barrette à broches (1) selon la revendication 1 ou 2, **caractérisée en ce que** les broches de brasage (4) présentent chacune une bride (9) sur laquelle repose le corps de connexion (3) avec la surface de corps inférieure (5b).

4. Barrette à broches (1) selon la revendication 3, **caractérisée en ce que** la bride (9) forme la région de brasage (8a) et l'extrémité inférieure d'une broche de brasage (4).

5. Barrette à broches (1) selon l'une quelconque des revendications précédentes, **caractérisée en ce que** le corps de connexion (3), au moins dans la région d'une broche de brasage (4) ou dans la région entre deux broches de brasage (4), présente un élargissement (6a, 6b) qui s'étend perpendiculairement depuis le plan et prolonge de manière plane la surface de corps supérieure (5a).

6. Barrette à broches (1) selon l'une quelconque des revendications précédentes, **caractérisée en ce que** le corps de connexion (3), au moins dans la région d'une broche de brasage (4) ou dans la région entre deux broches de brasage (4), présente deux élargissements opposés (6a, 6b) qui s'étendent perpendiculairement depuis le plan et prolongent de manière plane la surface de corps supérieure (5a) .

7. Barrette à broches (1) selon la revendication 6, **caractérisée en ce que** les élargissements (6a, 6b) s'étendent symétriquement par rapport aux deux côtés perpendiculairement au plan et prolongent la surface de corps supérieure (5a) dans la même mesure.

8. Barrette à broches (1) selon la revendication 6 ou 7, **caractérisée en ce que** le corps de connexion (3) présente des pattes d'appui (7b) pour supporter la barrette à broches (1) sur la carte à circuits imprimés (2), lesquelles sont disposées sur le côté inférieur de l'élargissement (6a, 6b) et s'étendent parallèlement aux broches de brasage (4) .

9. Barrette à broches (1) selon la revendication 8, **caractérisée en ce que** les pattes d'appui (7b) des élargissements (6a, 6b), considérées dans la direction d'étendue (C) de ceux-ci perpendiculairement au plan, sont disposées à chaque fois dans la région des extrémités extérieures de l'élargissement (6a, 6b).

10. Barrette à broches (1) selon l'une quelconque des revendications précédentes 6 à 9, **caractérisée en ce que** les élargissements (6a, 6b) sont disposés centralement dans la direction d'étendue (B) de la rangée de broches de brasage (4).

11. Barrette à broches (1) selon l'une quelconque des revendications précédentes, **caractérisée en ce que** le plastique est un sulfure de polyphénylène (PPS).

12. Procédé de montage d'une barrette à broches (1) selon l'une quelconque des revendications 1 à 11 sur une carte à circuits imprimés (2) comprenant des surfaces de contact pour le brasage de celle-ci avec les zones de brasage (8a) des broches de brasage (4), de la pâte de brasage étant tout d'abord appliquée sur les surfaces de contact, **caractérisé en ce que** la barrette à broches (1) est saisie au moyen d'une pipette à vide de telle sorte que l'embouchure de la pipette à vide s'applique contre la surface de corps supérieure (5a) du corps de connexion (3), une dépression étant générée dans la pipette à vide de telle sorte que le corps de connexion (3) soit aspiré contre l'embouchure de la pipette à vide, que la barrette à broches (1) soit appliquée au moyen de la pipette à vide sur la carte à circuits imprimés (2) de telle sorte que les zones de brasage (8a) des broches de brasage (4) soient amenées en contact avec la pâte de brasage de la surface de contact correspondante, et que les zones de brasage (8a) des broches de brasage (4) soient ensuite brasées avec les surfaces de contact.
